(19) Europäisches Patentamt / European Patent Office / Office européen des brevets

(11) **EP 2 884 372 B1**

(12) **FASCICULE DE BREVET EUROPEEN**

(45) Date de publication et mention
de la délivrance du brevet:
**01.02.2017 Bulletin 2017/05**

(21) Numéro de dépôt: **14197663.9**

(22) Date de dépôt: **12.12.2014**

(51) Int Cl.:
*G06F 3/0354* (2013.01)   *G06F 3/046* (2006.01)
*G01V 3/08* (2006.01)   *G06F 3/041* (2006.01)
*G06F 3/039* (2013.01)   *G01R 33/00* (2006.01)

(54) **Procédé de localisation d'objets magnétiques mobiles presentés devant un réseau de magnétomètres**

Lokalisierungsverfahren von beweglichen magnetischen Objekten, die sich vor einem Magnetometernetz befinden

Method for locating mobile magnetic objects presented before an array of magnetometers

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.12.2013 FR 1362730**

(43) Date de publication de la demande:
**17.06.2015 Bulletin 2015/25**

(73) Titulaire: **Commissariat à l'Énergie Atomique et aux Énergies Alternatives**
**75015 Paris (FR)**

(72) Inventeur: **Hautson, Tristan**
**38600 FONTAINE (FR)**

(74) Mandataire: **GIE Innovation Competence Group**
**310, avenue Berthelot**
**69372 Lyon Cedex 08 (FR)**

(56) Documents cités:
**FR-A1- 2 952 450      FR-A1- 2 988 862**
**GB-A- 2 310 930      US-A1- 2002 171 427**
**US-A1- 2003 095 115      US-B1- 7 932 718**

**Description**

L'invention concerne un procédé et un dispositif de localisation d'objets magnétiques mobiles présentés devant un réseau de magnétomètres. L'invention a également pour objet un support d'enregistrement d'informations pour la mise en oeuvre de ce procédé.

Les demandes de brevet FR2 988 862 et FR2 988 874 divulguent des procédés de localisation d'objets magnétiques mobiles présentés devant un réseau de magnétomètres comportant N magnétomètres tri-axes reliés mécaniquement les uns aux autres sans aucun degré de liberté pour conserver une distance connue entre chacun de ces magnétomètres, où N est un nombre entier supérieur ou égal à cinq. Ces procédés connus comportent :

> a) la mesure par chacun des magnétomètres de l'amplitude du champ magnétique le long de chacun de ses axes de mesure,
> b) l'estimation à partir des mesures des magnétomètres, des valeurs de plusieurs variables en résolvant un système actuel d'équations reliant ces variables à chaque mesure d'un magnétomètre tri-axe du réseau, chaque variable correspondant à la position ou à l'orientation ou à l'amplitude d'un moment magnétique d'un aimant permanent de l'objet magnétique,
>
> - l'itération des étapes a) et b) à des instants successifs dans le temps pour obtenir les valeurs estimées de chaque variable à ces différents instants successifs.

Ces procédés fonctionnent particulièrement bien. En particulier, ces procédés sont capables de localiser de nombreux objets magnétiques mobiles différents. De plus, ils sont aussi capables de localiser simultanément plusieurs objets magnétiques mobiles mécaniquement indépendants les uns des autres. A cause de ces capacités, on dit que ces procédés sont « flexibles ».

Toutefois, lorsque le nombre d'objets magnétiques mobiles à localiser simultanément augmente, la précision de la localisation de chacun de ces objets magnétiques mobiles diminue.

De l'état de la technique est également connu de: US7932718B1, US2003/095115A1, FR2952450A1, US2002/171427A1, FR2988862A1, GB2310930A.

L'invention vise à améliorer la précision de ces procédés connus de localisation d'objets magnétiques mobiles, notamment lorsque le nombre d'objets magnétiques mobiles à localiser simultanément augmente, tout en conservant leur flexibilité.

Elle a donc pour objet un tel procédé conforme à la revendication 1.

Le déposant a constaté que réduire le nombre de variables dans le système d'équations utilisé lors de l'étape b) permet de réduire le bruit d'estimation sur les positions et orientations estimées des objets magnétiques mobiles. Cela se traduit donc par une amélioration de la précision de localisation des objets magnétiques mobiles. Toutefois, cela réduit également la flexibilité du procédé.

Pour réduire ce nombre de variables sans nuire à la flexibilité du procédé, le procédé ci-dessus commence par utiliser un système d'équations ayant de nombreuses variables indépendantes. Ensuite, en fonction des objets mobiles présentés devant le réseau de magnétomètres, il identifie des équations supplémentaires reliant entre elles certaines variables du système actuel d'équations ou reliant une variable du système actuel d'équations à une valeur constante. Ces équations supplémentaires sont alors utilisées pour réduire le nombre de variables du système actuel d'équations. Ainsi, ce procédé adapte automatiquement et dynamiquement le nombre de variables du système d'équations en fonction des objets magnétiques mobiles à localiser. Cela permet de conserver la flexibilité du procédé tout en améliorant la précision de localisation.

De plus, lorsque le nombre de variables pour lesquelles une valeur doit être estimée lors de l'étape b) est réduit, le procédé de localisation est plus rapide.

Le procédé ci-dessus ne nécessite pas de stocker un grand nombre de systèmes d'équations prédéfinis mais simplement un système d'équations initial et des équations supplémentaires.

Enfin, diminuer le nombre de variables à estimer permet aussi d'accroître la robustesse du procédé.

Les modes de réalisation de ce procédé peuvent comporter une ou plusieurs des caractéristiques des revendications dépendantes.

Ces modes de réalisation du procédé de localisation présentent en outre les avantages suivants :

- utiliser les valeurs précédemment estimées pour identifier l'équation supplémentaire permet d'utiliser les magnétomètres à la fois pour localiser les objets magnétiques et pour sélectionner l'équation supplémentaire,
- en cas d'absence de variation d'une des variables, établir l'équation supplémentaire selon laquelle cette variable est égale à une valeur constante permet de diminuer le nombre de variables à estimer sans pour cela utiliser des connaissances préenregistrées sur le ou les comportements possibles de cette variable,
- utiliser un seuil pour déterminer si une variable varie, ce seuil étant déterminé à partir de la variation maximale observée pour cette variable, permet d'augmenter la précision du procédé,
- l'identification d'une équation supplémentaire en comparant les caractéristiques distinctives d'un objet mobile à des conditions de sélection préenregistrées permet de limiter le nombre de variables à estimer en prenant en compte une base de connaissances prédéfinie sur les déplacements possibles des objets magnétiques mobiles,

- obtenir la caractéristique distinctive à partir des mesures réalisées par le réseau de magnétomètres permet d'identifier l'équation supplémentaire en utilisant les mêmes magnétomètres que ceux utilisés pour localiser l'objet magnétique mobile ;

- ajouter à nouveau une variable au système actuel d'équations lorsque l'erreur d'estimation dépasse un certain seuil permet d'adapter automatiquement le procédé à un changement d'objet magnétique mobile ou à un changement dans son utilisation ;

- sélectionner la variable à réintroduire dans le système actuel d'équations à partir de l'erreur d'estimation calculée dans le cas où cette variable est absente du système d'équations et dans le cas où cette variable est présente dans le système d'équations permet de systématiquement diminuer l'erreur à chaque fois qu'une variable est réintroduite dans le système d'équations.

L'invention a également pour objet un support d'enregistrement d'informations comportant des instructions pour l'exécution du procédé ci-dessus, lorsque ces instructions sont exécutées par un calculateur électronique.

Enfin, l'invention a également pour objet un dispositif de localisation d'objets magnétiques mobiles conforme à la revendication 9.

L'invention sera mieux comprise à la lecture de la description qui va suivre, donnée uniquement à titre d'exemple non limitatif et faite en se référant aux dessins, sur lesquels :

- la figure 1 est une illustration schématique d'une interface homme-machine permettant de commander un appareil électrique.

- la figure 2 est une illustration partielle, en vue de dessus, d'un réseau de magnétomètres mis en oeuvre dans l'interface homme-machine de la figure 1 ;

- la figure 3 est une illustration schématique, en coupe verticale, d'un curseur utilisable dans l'interface de la figure 1 ;

- la figure 4 est une illustration schématique, en coupe verticale, d'un bouton utilisable dans l'interface de la figure 1 ;

- la figure 5 est une illustration schématique d'une base de données utilisée dans l'interface de la figure 1 ;

- la figure 6 est un organigramme d'un procédé de commande d'un appareil électrique à l'aide de l'interface homme-machine de la figure 1.

Dans ces figures, les mêmes références sont utilisées pour désigner les mêmes éléments.

Dans la suite de cette description, les caractéristiques et fonctions bien connues de l'homme du métier ne sont pas décrites en détails.

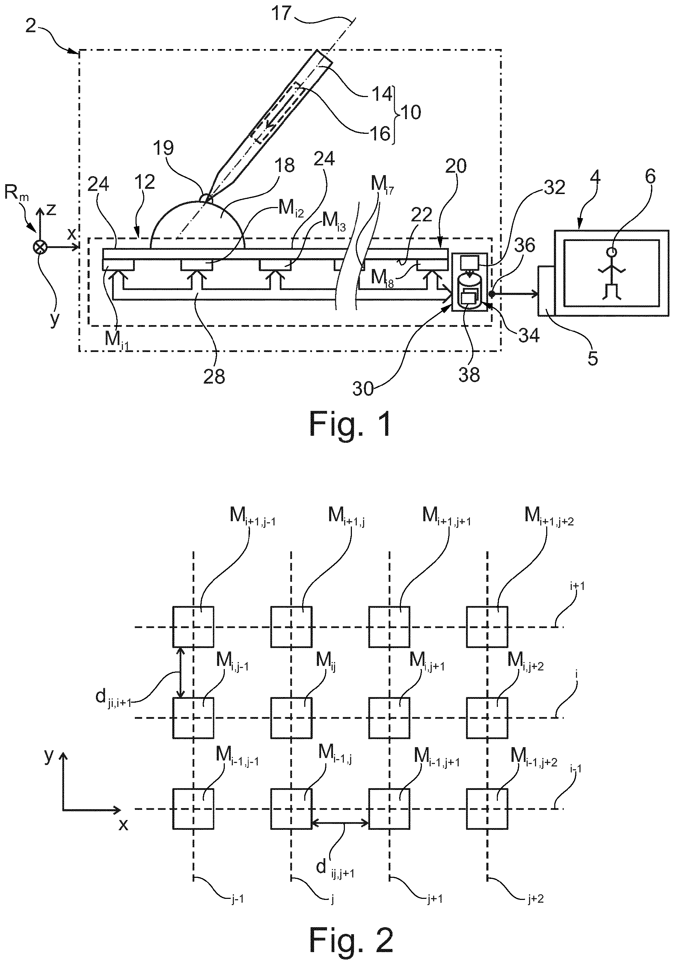

La figure 1 représente une interface homme-machine 2 permettant de commander un appareil électrique 4. Ici, l'appareil électrique comporte un écran et une unité 5 de commande capable de commander l'affichage d'une image sur cet écran.

Ici, le fonctionnement de l'interface 2 est illustré dans le cas où l'unité 5 est une console de jeux vidéo. Par exemple, l'unité 5 commande le déplacement d'un personnage 6 sur l'écran. Toutefois, l'interface 2 est utilisable dans de nombreuses autres applications comme cela est décrit à la fin de cette description.

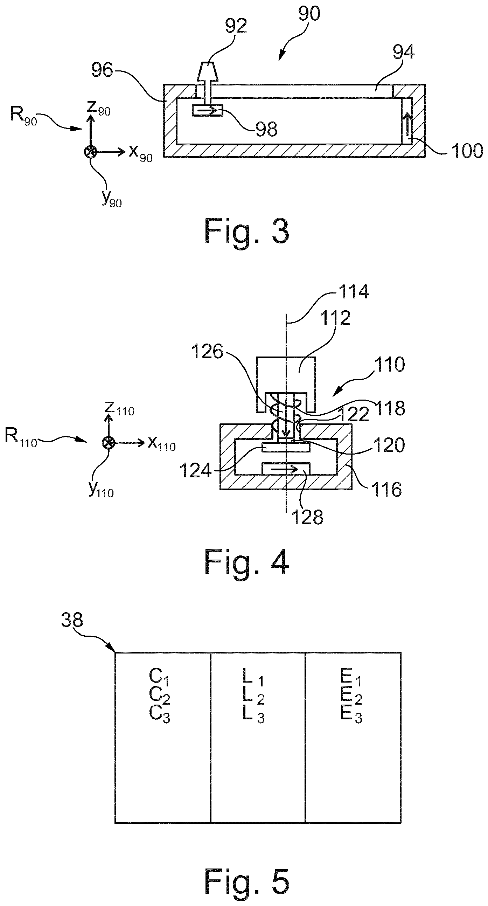

L'interface 2 comporte plusieurs ustensiles actionnables directement à la main par un être humain, dénommé « utilisateur » par la suite. Chacun de ces ustensiles comporte au moins un objet magnétique. Ici chaque objet magnétique est un aimant permanent. Pour simplifier la figure 1, seul un ustensile 10 est représenté sur cette figure. D'autres ustensiles de l'interface 2 sont décrits en référence aux figures 3 et 4. L'interface 2 comporte également un dispositif 12 de localisation de chaque aimant permanent.

Dans ce mode de réalisation, pour modifier la configuration de l'interface 2, chaque ustensile est librement déplaçable, directement par la main de l'utilisateur, dans un repère orthogonal Rm fixé sans aucun degré de liberté au dispositif 12. Ici, les directions X et Y du repère Rm sont horizontales et la direction Z est verticale. A cet effet, chaque ustensile pèse moins d'un kilo et, de préférence, moins de 200g. Les dimensions de chaque ustensile sont suffisamment réduites pour qu'il puisse être saisi et déplacé par une seule main de l'utilisateur.

Dans ce mode de réalisation, l'ustensile 10 comprend une manette 14, un aimant permanent 16 et un support 18. La manette 14 a une forme oblongue pour former une poignée facilement saisissable par l'utilisateur. Elle s'étend le long d'un axe longitudinal 17. La manette 14 est destinée à être utilisée comme un joystick. A cet effet, une extrémité inférieure de la manette 14 est fixée au support 18 par l'intermédiaire d'une rotule 19. Le support 18 est pourvu d'une face plane inférieure destinée à être fixée ou à reposer sur un plan de manière à immobiliser, dans le repère Rm, la position de la rotule 19 lorsque l'ustensile 10 est utilisé. Ainsi, la manette 14 peut être inclinée librement par l'utilisateur autour du centre de rotation de la rotule 19. Lors de son utilisation, la manette 14 présente donc trois degrés de liberté en rotation.

Par exemple, la manette 14, le support 18 et la rotule 19 sont entièrement réalisés dans un matériau non-magnétique, c'est-à-dire un matériau ne présentant pas de propriété magnétique mesurable par le dispositif 12. Ce matériau est par exemple du plastique. La position de la manette 14 autour des axes X, Y et Z est localisée à partir de la position de l'aimant 16. L'aimant 16 présente un moment magnétique non nul même en absence de champ magnétique extérieur

Typiquement, dans cette description, le champ magnétique coercitif de chaque aimant est supérieur à 100 A.m$^{-1}$ ou 500 A.m$^{-1}$. Par exemple, il est réalisé en matériau ferro- ou ferrimagnétique. La puissance de chaque aimant permanent est typiquement supérieure à 0,01 A.m$^2$ ou 0,1 A.m$^2$.

L'aimant 16 est fixé sans aucun degré de liberté sur la manette 14. La direction du moment magnétique de l'aimant 16 est ici confondue avec l'axe longitudinal 17 de la manette 14. Sur la figure 1 et les suivantes, la direction du moment magnétique d'un aimant est représentée par une flèche. La plus grande longueur de cet aimant est notée L par la suite.

Lors de l'utilisation de la manette 14, les coordonnées de l'aimant 16 sont reliées les unes aux autres par la relation vectorielle suivante : P + Rd*(M/‖M‖) = P$_0$, où :

- P$_0$ est le vecteur codant la position du centre de rotation de la rotule 19 de l'ustensile 10 dans le repère Rm,
- P est le vecteur codant la position du centre géométrique de l'aimant 16 dans le repère Rm,
- M est le moment magnétique de l'aimant 16,
- ‖M‖ est l'amplitude du moment magnétique M,
- Rd est la distance qui sépare le centre de rotation de la rotule 19 du centre géométrique de l'aimant 16.

A partir de cette relation vectorielle, il est possible d'établir trois équations supplémentaires reliant entre elles les variables codant la position, l'orientation et l'amplitude du moment magnétique de l'aimant 16. Par exemple, ces équations supplémentaires sont les suivantes :

$$\frac{-Rd * Mx}{\sqrt{M x^2 + M y^2 + M z^2}} = Px - Pox \quad (1)$$

$$\frac{-Rd * My}{\sqrt{M x^2 + M y^2 + M z^2}} = Py - Poy \quad (2)$$

$$\frac{-Rd * Mz}{\sqrt{M x^2 + M y^2 + M z^2}} = Pz - Poz \quad (3)$$

où :

- Mx, My et Mz sont les projections orthogonales du moment magnétique M sur les axes X, Y et Z du repère Rm,
- Px, Py et Pz sont les coordonnées du point P sur les axes X, Y et Z du repère Rm, et
- Pox, Poy and Poz sont les coordonnées du point P$_0$ sur les axes X, Y et Z du repère Rm.

Ces équations expriment le fait :

- que le centre géométrique de l'aimant 16 est toujours situé sur un sphère centrée sur le centre de rotation de la rotule 19 et de rayon Rd, et

- que le moment magnétique de l'aimant 16 pointe en permanence sur le centre de rotation de la rotule 19.

Le centre de géométrie d'un objet est le barycentre de l'ensemble des points de cet objet en affectant le même poids à chacun de ces points.

Pour simplifier la description, dans la suite de cette description, les équations supplémentaires sont exprimées dans un repère local lié sans aucun degré de liberté à l'ustensile. Il est à la portée de l'homme du métier d'exprimer ces mêmes équations supplémentaires dans le repère Rm en tenant compte des coordonnées et de l'orientation du repère local par rapport au repère Rm. Il s'agit simplement d'un changement de repère.

Le dispositif 12 permet de localiser un ou plusieurs aimants dans le repère Rm. Par localisation d'un aimant, on entend ici la détermination de la position et de l'orientation de l'aimant 16 dans le repère Rm. La position est définie sans ambiguïté par les valeurs de trois variables, par exemple les coordonnées x, y et z dans le repère Rm. Plus précisément, dans le cas d'un aimant, les variables x, y et z sont les coordonnées du centre géométrique de l'aimant. L'orientation du moment magnétique d'un aimant est définie dans le repère Rm par les valeurs de deux variables $\theta_y$ et $\theta_z$. Ici, les variables $\theta_y$ et $\theta_z$ sont les angles du moment magnétique de l'aimant, respectivement, par rapport aux axes Y et Z du repère Rm. Le dispositif 12 détermine également une sixième variable A. La variable A est l'amplitude du moment magnétique de l'aimant.

Le dispositif 12 comporte à cet effet un réseau de N magnétomètres tri-axes M$_{ij}$. Sur la figure 1, les traits ondulés verticaux indiquent qu'une partie du dispositif 12 n'a pas été représentée.

Typiquement, N est supérieur à cinq et, de préférence, supérieur à seize ou trente-deux. Ici, N est supérieur ou égal à soixante-quatre.

Dans ce mode de réalisation, les magnétomètres M$_{ij}$ sont alignés en lignes et en colonnes pour former une matrice. Ici, cette matrice comporte huit lignes et huit colonnes. Les indices i et j identifient, respectivement, la ligne et la colonne de cette matrice à l'intersection de laquelle se trouve le magnétomètre M$_{ij}$. Sur la figure 1, seuls les magnétomètres M$_{i1}$, M$_{i2}$, M$_{i3}$, M$_{i4}$ et M$_{i8}$ d'une ligne i sont visibles. La position des magnétomètres M$_{ij}$ les uns par rapport aux autres est décrite plus en détail en référence à la figure 2.

Chaque magnétomètre M$_{ij}$ est fixé sans aucun degré de liberté aux autres magnétomètres. A cet effet, les magnétomètres M$_{ij}$ sont fixés sans aucun degré de liberté sur une face arrière 22 d'une plaque rigide 20. Cette plaque rigide présente une face avant 24 tournée vers l'aimant 16. La plaque 20 est réalisée dans un matériau non magnétique rigide. Par exemple, la plaque 20 est en verre.

Chaque magnétomètre M$_{ij}$ mesure la direction et l'intensité du champ magnétique généré par les aimants présents devant la face 24. Pour cela, chaque

magnétomètre $M_{ij}$ mesure la norme de la projection orthogonale du champ magnétique au niveau de ce magnétomètre $M_{ij}$ sur trois axes de mesure de ce magnétomètre. Ici, ces trois axes de mesure sont orthogonaux entre eux. Par exemple, les axes de mesure de chacun des magnétomètres $M_{ij}$ sont, respectivement, parallèles aux axes X, Y et Z du repère. La sensibilité du magnétomètre $M_{ij}$ est par exemple de $4*10^{-7}$T.

Chaque magnétomètre $M_{ij}$ est raccordé par l'intermédiaire d'un bus 28 de transmission d'informations à une unité de traitement 30.

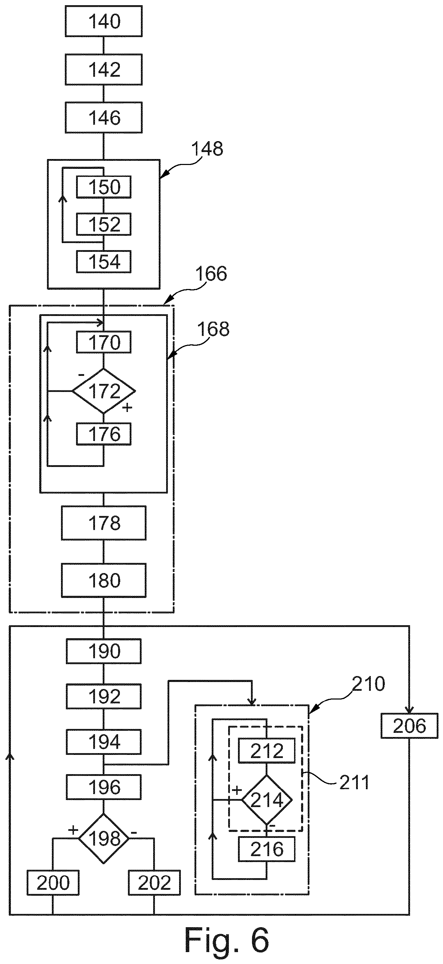

L'unité de traitement 30 est capable, pour chaque aimant, de le localiser dans le repère Rm et d'estimer l'amplitude de son moment magnétique à partir des mesures des magnétomètres $M_{ij}$. A cet effet, l'unité 30 comporte un calculateur électronique 32 programmable apte à exécuter des instructions enregistrées sur un support d'enregistrement d'informations. L'unité 30 comporte donc aussi une mémoire 34 contenant les instructions nécessaires pour l'exécution par le calculateur 32 du procédé de la figure 6. Dans ce mode de réalisation, pour chaque nombre P d'objets magnétiques susceptibles d'être simultanément utilisés dans l'interface 2, l'unité 30 implémente un modèle mathématique $M_P$ associant chaque mesure d'un magnétomètre $M_{ij}$ aux positions, orientations et amplitudes des moments magnétiques de P objets magnétiques dans le repère Rm. Chaque modèle $M_P$ se présente sous la forme d'un système d'équations dans lequel un premier jeu de variables représente les positions et orientations des P objets magnétiques ainsi que les amplitudes des moments magnétiques de ces objets. Un second jeu de variables représente les mesures des magnétomètres $M_{ij}$. Pour obtenir les positions, orientations et amplitudes des moments magnétiques des P objets magnétiques, les variables du premier jeu sont les inconnues et les valeurs des variables du second jeu sont connues. Ce modèle est typiquement construit à partir des équations physiques du magnétisme. Ce modèle est paramétré par les distances connues entres les magnétomètres $M_{ij}$. Ici, les objets magnétiques sont les aimants permanents. Pour construire ce modèle, chaque aimant permanent est approximé par un dipôle magnétique. Cette approximation n'introduit que très peu d'erreurs si la distance entre l'aimant permanent et le magnétomètre $M_{ij}$ est supérieure à 2L et, de préférence, supérieure à 3L, où L est la plus grande dimension de l'aimant permanent. Typiquement, L est inférieur à 20 cm et, de préférence, inférieur à 10 ou 5 cm.

Ici, le modèle $M_P$ est non linéaire. L'unité 30 le résout en mettant en oeuvre un algorithme d'estimation de sa solution. Par exemple, l'algorithme utilisé est un filtre de Kalman d'ensemble plus connu sous le terme anglais de « Unscented Kalman Filter ».

Étant donné que chaque objet magnétique est caractérisé par trois variables pour connaître sa position, deux variables pour connaître son orientation et une variable pour connaître l'amplitude de son moment magnétique, le nombre maximum d'objets magnétiques simultanément localisables par le réseau de N magnétomètres est inférieur à N/2. Dès lors, la valeur du nombre P est inférieure ou égale à N/2 et, de préférence, inférieure à N/5 ou N/10 ou N/20 pour avoir des mesures redondantes. La redondance des mesures permet d'améliorer la précision de la localisation des objets magnétiques.

Dans ce mode de réalisation, seul cinq modèles mathématiques $M_1$, $M_2$, $M_3$, $M_4$ et $M_5$ sont implémentés dans l'unité 30 pour, respectivement, 1, 2, 3, 4 et 5 aimants permanents simultanément présents devant la face 24.

L'unité 30 est également capable de transmettre une commande à l'appareil 4 par l'intermédiaire d'une interface 36 reliée à cet appareil 4.

La mémoire 34 comporte aussi une base 38 de données dans laquelle sont enregistrées plusieurs lois de commande de l'appareil 4. Chaque loi de commande permet de générer la commande de l'appareil 4 correspondant à l'état actuel de l'ustensile auquel elle est associée. A cet effet, chaque loi de commande associe :

- à au moins un état possible de l'ustensile, une commande de l'appareil 4, et
- à un autre état possible du même ustensile, une autre commande de l'appareil 4 ou une absence de commande de l'appareil 4.

La loi de commande détermine donc comment fonctionne l'appareil 4 en réponse à l'actionnement, par l'utilisateur, de l'ustensile qui est associé à cette loi de commande. Cette base 38 est décrite plus en détail en référence à la Figure 5.

La figure 2 représente une partie des magnétomètres $M_{ij}$ du dispositif 12. Ces magnétomètres $M_{ij}$ sont alignés en lignes i parallèles à la direction X. Ces magnétomètres sont également alignés en colonnes j parallèles à la direction Y pour former une matrice. Les lignes i et les colonnes j sont disposées dans l'ordre des indices croissants.

Le centre du magnétomètre $M_{ij}$ se trouve à l'intersection de la ligne i et de la colonne j. Le centre du magnétomètre correspond au point où le champ magnétique est mesuré par ce magnétomètre. Ici, les indices i et j appartiennent à l'intervalle [1 ; 8].

Les centres de deux magnétomètres $M_{ij}$ et $M_{i,j+1}$ immédiatement consécutifs le long d'une ligne i sont séparés par une distance connue $d_{i,j,j+1}$. De façon similaire, le centre de deux magnétomètres $M_{ij}$ et $M_{i+1,j}$ immédiatement consécutifs le long d'une même colonne j sont séparés par une distance connue $d_{j,i,i+1}$.

Dans le cas particulier décrit ici, quelle que soit la ligne i, la distance $d_{i,j,j+1}$ est la même. Cette distance est donc notée $d_j$. De façon similaire, quelle que soit la colonne j, la distance $d_{j,i,i+1}$ entre deux magnétomètres est la même. Cette distance est donc notée $d_i$.

Ici, les distances $d_i$ et $d_j$ sont toutes les deux égales à d.

Typiquement, la distance d est inférieure, et de préférence deux fois inférieure, à la plus petite distance qui peut exister entre deux objets magnétiques simultanément présent devant la face 24 lors d'une utilisation normale de l'interface 2. Ici, la distance d est comprise entre 1 et 4 cm lorsque :

- la puissance de l'aimant permanent est de 0,5 A.m$^2$,
- la sensibilité des magnétomètres est de 4*10$^{-7}$T, et
- le nombre de magnétomètres $M_{ij}$ est de soixante-quatre.

Les figures 3 et 4 représentent d'autres ustensiles utilisables à la place de l'ustensile 10 ou simultanément avec l'ustensile 10 dans l'interface 2.

La figure 3 représente un curseur 90. Ce curseur permet, par exemple, de régler la valeur d'un paramètre de l'appareil 4. Ce curseur 90 comporte à cet effet un coulisseau 92 monté déplaçable en translation dans une fente rectiligne 94 ménagée dans une face supérieure d'un boîtier 96. L'utilisateur peut faire coulisser à la main le coulisseau 92 pour modifier l'état du curseur 90. Dans le cas du curseur 90, chaque état correspond à une position particulière du coulisseau 92 le long de la fente 94.

Pour mesurer la position du coulisseau 92 le long de la fente 94, le curseur 90 est équipé :

- d'un aimant permanent 98 fixé sans aucun degré de liberté au coulisseau 92, et
- d'un aimant permanent 100 fixé sans aucun degré de liberté au boîtier 96.

On définit un repère orthogonal local $R_{90}$ lié sans aucun degré de liberté au boîtier 96 est dont :

- l'axe $X_{90}$ est parallèle à la fente 92,
- l'axe $Y_{90}$ est parallèle au fond du boîtier 96,
- l'axe $Z_{90}$ est perpendiculaire au fond du boîtier 96, et
- l'origine est confondue avec le centre géométrique de l'aimant 100.

Pour des raisons de clarté, le repère $R_{90}$ est représenté à côté du curseur 90 sur la figure 3.

Dans ce mode de réalisation, la direction du moment magnétique de l'aimant 98 est parallèle à la direction $x_{90}$. La direction du moment magnétique de l'aimant 100 est parallèle à la direction $z_{90}$.

Le nombre de degré de liberté du curseur 92 par rapport au boîtier 96 est limité à un degré de liberté en translation le long de l'axe $X_{90}$. Dans ces conditions, les équations supplémentaires suivantes existent entre les coordonnées des aimants 98 et 100 dans le repère $R_{90}$ : $z_{98} = Z_{100} + h_{98}$ et $y_{98} = Y_{100}$, où :

- $x_{98}$, $y_{98}$, $z_{98}$ sont les coordonnées dans le repère $R_{90}$ du centre géométrique de l'aimant 98,
- $x_{100}$, $y_{100}$, $z_{100}$ sont les coordonnées dans le repère $R_{90}$ du centre géométrique de l'aimant 100,

- $h_{98}$, est une valeur numérique constante connue fonction des dimensions de l'ustensile 90.

On a également les équations supplémentaires suivantes : $\theta_{y98} = \theta_{y100}$ et $\theta_{z100} = \theta_{z98} + 90°$, où :

- $\theta_{y98}$ et $\theta_{z98}$ sont les angles entre la direction du moment magnétique de l'aimant 98 est les axes $y_{90}$ et $z_{90}$, et
- $\theta_{y100}$ et $\theta_{z100}$ sont les angles entre la direction du moment magnétique de l'aimant 100 est les axes $y_{90}$ et $z_{90}$.

Les amplitudes des moments magnétiques des aimants 98 et 100 sont uniques dans l'interface 2 et différentes l'une de l'autre.

La figure 4 représente un bouton 110. Ce bouton 110 est déplaçable à la main par un utilisateur entre un état de repos (représenté sur la figure 4) et à un état enfoncé. Typiquement, le bouton 110 est destiné à déclencher une action de l'appareil 4 uniquement lorsqu'il atteint son état enfoncé.

Ce bouton 110 comporte une touche 112 uniquement déplaçable en translation, le long d'un axe 114 solidaire d'un boîtier 116, entre une position de repos (représenté sur la figure 4) et une position enfoncée. Dans la figure 4, l'axe 114 est vertical. Les états de repos et enfoncé correspondent, respectivement, aux positions de repos et enfoncée de la touche 112.

Le bouton 110 comporte un ressort 118 interposé entre une partie inférieure du bouton 112 et une face supérieure du boîtier 116. Une tige rectiligne 120 s'étend le long de l'axe 114, cette tige 120 est fixée, d'un côté, sans aucun degré de liberté, à la touche 112 et, de l'autre côté, à une butée 124. Cette tige 120 est montée à coulissement à l'intérieur d'un orifice 122 ménagé dans la face supérieure du boîtier 116. La butée 124 permet de retenir l'extrémité inférieure de cette tige 120 à l'intérieur du boîtier 116.

Pour déterminer l'état dans lequel se trouve le bouton 110, la tige 120 comporte un aimant permanent 126 fixé sans aucun degré de liberté sur cette tige. Dans ce mode de réalisation, la direction du moment magnétique de l'aimant 126 est confondue avec l'axe 114. Un autre aimant permanent 128 est également fixé sans aucun degré de liberté sur le fond du boîtier 116.

Dès lors, l'état dans lequel se trouve le bouton 110 peut être établi à partir de la position relative de l'aimant 126 par rapport à l'aimant 128. Par exemple, l'état est établi à partir de la valeur d'une distance $d_{110}$ et d'un seuil $S_0$. La distance $d_{110}$ est la distance la plus courte qui sépare les centres géométriques des aimants 126 et 128. Le seuil $S_0$ est utilisé pour discriminer l'état enfoncé de l'état de repos. Si la distance $d_{110}$ est inférieure au seuil $S_0$, cela signifie que le bouton 110 est dans son état enfoncé. A l'inverse, si la distance $d_{110}$ est supérieure à ce seuil $S_0$, le bouton 110 est dans son état de repos.

On définit un repère orthogonal local $R_{110}$ fixé sans aucun degré de liberté au bouton 110. Pour des raisons de clarté, il est représenté à côté du bouton 110 sur la figure 4. L'origine du repère $R_{110}$ est confondue avec le centre géométrique de l'aimant 128. Les axes $X_{110}$ et $Z_{110}$ de ce repère $R_{110}$ sont confondus avec les directions des moments magnétiques, respectivement, des aimants 128 et 126. L'axe $Z_{110}$ de ce repère $R_{110}$ est donc confondu avec l'axe 114.

L'aimant 126 ne présente qu'un seul degré de liberté en translation par rapport à l'aimant 128. Dans ces conditions, les équations supplémentaires suivantes relient entre elles les coordonnées des aimants 126 et 128 dans le repère $R_{110}$ : $x_{126} = x_{128}$, $y_{126} = y_{128}$, $\theta_{Y126} = \theta_{Y128}$, et $\theta_{Z126} = \theta_{Z128} + 90°$, où :

- $x_{126}$, $y_{126}$, $z_{126}$ sont les coordonnées dans le repère $R_{110}$ du centre géométrique de l'aimant 126,
- $x_{128}$, $y_{128}$, $z_{128}$ sont les coordonnées dans le repère $R_{110}$ du centre géométrique de l'aimant 128.

Ici, les aimants 126 et 128 sont identiques.

La figure 5 représente la base de données 38. Cette base 38 comporte pour chaque ustensile $U_i$:

- une condition Ci de sélection permettant de sélectionner, à partir d'une caractéristique distinctive de l'ustensile $U_i$, seulement cet ustensile $U_i$ et non pas les autres ustensiles ayant un agencement d'aimants différents et susceptibles d'être utilisés dans l'interface 2,
- une loi de commande $L_i$ préenregistrée,
- un ensemble $E_i$ d'équations supplémentaires définissant la ou les relations prédéterminées qui existent entre les coordonnées et les orientations des moments magnétiques des aimants de cet ustensile.

Par la suite, on suppose que la caractéristique distinctive de chaque ustensile est l'amplitude du ou des moments magnétiques de ses aimants permanents.

De préférence, la condition de sélection s'exprime sous la forme d'une plage de valeurs à laquelle doit appartenir la caractéristique distinctive de l'ustensile pour être vérifiée.

Si la condition Ci est vérifiée par un aimant permanent ou une paire d'aimants permanents, alors la loi $L_i$ et l'ensemble $E_i$ sont associés à l'ustensile équipé de cet aimant ou paire d'aimants. L'indice « i » identifie la loi $L_i$ et l'ensemble $E_i$ associés à cette condition Ci par la base 38. Ici, chaque condition Ci porte sur les valeurs des variables estimées pour les aimants permanents qui équipent un ustensile et qui, généralement, ne sont pas utilisées pour établir l'état dans lequel se trouve actuellement cet ustensile.

A titre d'illustration, un exemple de contenu de la base 38 va maintenant être décrit.

La loi $L_i$ est une loi de commande qui utilise uniquement les valeurs des variables $\theta_Y$ et $\theta_Z$. Plus précisément, elle transforme chaque valeur des angles $\theta_Y$ et $\theta_Z$ en une commande respective de l'appareil 4. Par exemple, cette commande peut provoquer un déplacement du personnage 6 dans une direction spécifiée par les valeurs des angles $\theta_Y$ et $\theta_Z$.

Cette loi $L_1$ est associée à une condition $C_1$. La condition $C_1$ est la suivante : la valeur de la variable A doit être comprise entre $S_1$ et $S_2$, où $S_1$ et $S_2$ sont des limites prédéfinies telles que seule l'amplitude du moment magnétique de l'aimant 16 soit comprise entre ces limites. Cette loi $L_1$ est donc destinée à être associée à l'ustensile 10. Si le dispositif 12 détermine que la valeur de la variable A d'un aimant permanent est comprise entre $S_1$ et $S_2$, alors il utilise la loi $L_1$ pour convertir les valeurs des angles $\theta_Y$ et $\theta_Z$ de ce même aimant en une commande l'appareil 4. Dès lors, en modifiant l'inclinaison de l'ustensile 10, il est possible de commander l'appareil 4. Ceci reste vrai quelle que soit la position de l'ustensile 10 par rapport au dispositif 12 à partir du moment où la présence de l'aimant 16 peut être détectée. L'emplacement de l'ustensile 10 peut donc librement être choisi par l'utilisateur, ce qui correspond à une infinité de configuration possible pour l'interface 2. L'ensemble $E_1$ comporte l'équation supplémentaire décrite en référence à la figure 1.

La loi $L_2$ est une loi de commande qui utilise la valeur d'un distance entre deux aimants permanents pour générer une commande de réglage d'un paramètre de l'appareil 4 en fonction de cette distance. Cette loi $L_2$ précise que la distance est mesurée entre :

- un aimant permanent dont l'amplitude du moment magnétique est comprise entre des limites $S_{71}$ et $S_{81}$ prédéfinies telle que seul l'aimant 98 puisse satisfaire cette condition, et
- un aimant permanent dont l'amplitude du moment magnétique est comprise entre des limites $S_{72}$ et $S_{82}$ prédéfinies telle que seul l'aimant 100 puisse satisfaire cette condition.

Cette loi de commande est typiquement conçue pour être associée au curseur 90 de sorte que la distance correspond à la distance $d_{90}$. A cet effet, la loi $L_2$ est associée à une condition $C_2$. Cette condition $C_2$ est la suivante : la valeur de la variable A d'un aimant permanent est comprise entre les limites $S_{72}$ et $S_{82}$.

Avec une telle condition $C_2$, la loi $L_2$ est associée au curseur 90. L'ensemble $E_2$ comporte les équations supplémentaires décrites en référence à la figure 3.

La loi $L_3$ est une loi de commande qui utilise uniquement la distance la plus courte entre deux aimants permanents identiques pour générer une commande de l'appareil 4. Ici, la loi $L_3$ est destiné à être associée au bouton 110 de sorte que la distance la plus courte correspond à la distance $d_{110}$. Par exemple, la loi de commande $L_3$ est la suivante :

- si la distance $d_{110}$ est supérieure au seuil $S_0$, alors

l'unité 30 ne génère aucune commande de l'appareil 4, et

- si la distance $d_{110}$ est inférieure ou égale au seuil $S_0$, alors l'unité 30 génère et transmet une commande à l'appareil 4.

La loi $L_3$ est associée à une condition $C_3$. Ici, cette condition $C_3$ est la suivante :

- les valeurs des variables A de deux d'aimants permanents distincts sont comprises toutes les deux entre des limites $S_9$ et $S_{10}$, et
- la distance la plus courte entre ces deux aimants est inférieure à un seuil $D_{max110}$.

Les limites $S_9$ et $S_{10}$ sont des constantes prédéfinies telles que seule l'amplitude du moment magnétique des aimants 126 et 128 soit comprise entre ces limites. La valeur du seuil $D_{max110}$ est choisi égale à la plus grande valeur possible de la distance $d_{110}$. L'ensemble $E_3$ comporte les équations supplémentaires décrites en référence à la figure 4.

Le fonctionnement de l'interface 2 va maintenant être décrit plus en détail en référence au procédé de la figure 6.

Ce procédé débute par une phase 140 d'initialisation lors de laquelle les lois $L_i$, les ensembles $E_i$ et les conditions Ci sont enregistrées dans la base 38.

Ensuite, on procède à une phase 142 de configuration de l'interface 2. Lors de cette phase 142, l'utilisateur choisit un ou plusieurs ustensiles parmi les ustensiles 10, 90 et 110. Ici, on suppose qu'il ne dispose que d'un seul exemplaire de l'ustensile 10 et de deux exemplaires des ustensiles 90 et 110. Ensuite, il les dispose librement sur la face 24 du dispositif 12. De plus, il s'assure que la configuration réalisée ne conduit pas à avoir simultanément plus de cinq aimants permanents devant la face 24. L'interface homme-machine 2 est alors configurée. La suite de cette description est faite dans le cas particulier où l'utilisateur a disposé sur la face 24 un exemplaire de chacun des ustensiles 10, 90 et 110.

Il est alors possible de procéder à l'utilisation de cette interface 2 pour commander l'appareil 4.

Cela débute par une étape 146 lors de laquelle les magnétomètres $M_{ij}$ mesurent simultanément le champ magnétique du ou des aimants simultanément présents devant la face 24.

Ensuite, lors d'une étape 148, l'unité 30 estime à partir des mesures des magnétomètres $M_{ij}$ la position, l'orientation et l'amplitude du moment magnétique de chacun des aimants présents.

Pour cela, lors d'une opération 150, l'unité 30 résout le système d'équations du modèle $M_i$ à un dipôle magnétique. Elle obtient un jeu de coordonnées $x_1$, $y_1$, $z_1$, $\theta_1$ et $\varphi_1$ et une amplitude $A_1$ correspondant à l'estimation de la position, l'orientation et l'amplitude d'un seul aimant permanent.

Ensuite, lors d'une opération 152, l'unité 30 calcule une erreur d'estimation $E_1$ représentative de l'écart entre :

- des valeurs estimées des mesures des magnétomètres, calculées à partir du système d'équations $M_1$ et à partir des position, orientation et amplitude obtenues à l'issue de l'opération 150, et
- les mesures des magnétomètres relevées lors de l'étape 146.

L'erreur est estimée pour chaque magnétomètre. Ici, l'erreur d'estimation globale résultant de l'utilisation du modèle $M_1$ est par exemple obtenue en moyennant les erreurs calculées pour chacun des magnétomètres.

Dans le cas où l'algorithme utilisé pour résoudre le modèle est un filtre de Kalman d'ensemble ou étendu, la résolution de ce système d'équations lors de l'opération 150 fournit également une estimation de cette erreur $E_1$.

Les étapes 150 et 152 sont réalisées pour P = 1 jusqu'à P = 5. De préférence, les étapes 150 et 152 pour chaque valeur de P sont réalisées en parallèle.

Ensuite, lors d'une opération 154, l'unité 30 sélectionne le modèle $M_P$ qui donne l'erreur $E_P$ la plus petite. Ainsi, s'il n'y a qu'un seul aimant permanent devant la face 24, l'unité 30 sélectionne automatiquement le modèle $M_1$. Si, au contraire, il y a deux aimants permanents, l'unité 30 sélectionne automatiquement le modèle $M_2$ et ainsi de suite. Ici, c'est le modèle $M_5$ qui est automatiquement sélectionné car l'interface 2 comporte cinq aimants permanents. Ce modèle $M_5$ comporte trente variables dont les valeurs sont inconnues.

A l'issue de cette étape 148, le calculateur dispose d'une première estimation des valeurs des variables x, y, z, $\theta_Y$, $\theta_Z$ et A pour chacun de cinq aimants. Cette première estimation est celle obtenue suite à l'exécution de l'opération 150 en utilisant le modèle $M_5$.

L'étape 148 se poursuite alors par une première phase 166 d'adaptation automatique du modèle $M_5$ à la configuration réalisée par l'utilisateur lors de l'étape 142.

Cette phase 166 débute par une étape 168 d'identification des ensembles $E_i$ qui peuvent être utilisés pour réduire le nombre de variables à estimer dans le modèle $M_5$. A cet effet, lors de l'étape 168, le calculateur 32 identifie les ustensiles présents devant la face 24.

Par exemple, lors d'une opération 170, le calculateur acquière la caractéristique distinctive de chaque ustensile présent devant la face 24. Ici, cette caractéristique distinctive est obtenue à partir de la précédente estimation de la position, orientation et amplitude de chaque aimant permanent. Dans ce cas particulier, cette caractéristique distinctive est soit l'amplitude du moment magnétique estimé d'un aimant permanent, soit les amplitudes estimées des moments magnétiques d'une paire d'aimants permanents. Les amplitudes estimées sont par exemple celles estimées lors de l'exécution de l'opération 150 avec le modèle $M_5$.

Ensuite, lors d'une opération 172, le calculateur 32 compare chaque caractéristique distinctive acquise à chaque condition Ci de la base 38.

Si la caractéristique distinctive acquise correspond à l'une des conditions Ci alors, lors d'une opération 176, un ustensile est identifié. A chaque fois qu'un ustensile est identifié, un identifiant de cet ustensile est ajouté à une liste d'ustensiles identifiés. Cette liste d'ustensiles identifiés contient également pour chaque ustensile identifié l'ensemble $E_i$ et la loi $L_i$ associés à cet ustensile par la base 38.

Si la caractéristique distinctive acquise ne correspond à aucune des conditions Ci, alors l'ustensile n'est pas identifié.

A l'issue de l'étape 168, les équations supplémentaires utilisables pour diminuer le nombre de variables du modèle $M_5$ sont donc identifiées. Toutefois, chacune de ces équations supplémentaires, exprimée dans le repère Rm, dépend des coordonnées de l'origine et de l'orientation des axes du repère locale par rapport au repère Rm.

Par conséquent, le procédé se poursuit par une étape 178 lors de laquelle, pour le repère local de chaque ustensile identifié, le calculateur 32 détermine :

- la position de son origine dans le repère Rm, et si nécessaire,
- l'orientation de ses axes dans le repère Rm.

Pour cela, le calculateur 32 utilise la position et l'orientation estimées du et des aimants permanents de l'ustensile dans le repère Rm et des informations préenregistrées sur la position du repère local par rapport aux aimants permanents de cet ustensile.

Par exemple, dans le cas de l'ustensile 10, la position de l'origine du repère $R_{10}$ est déterminée en translatant la position estimée de l'aimant 16 dans le repère Rm d'une distance Rd dans la direction de son moment magnétique et en se rapprochant de la face 24.

Dans le cas de l'ustensile 90, la position de l'origine du repère $R_{90}$ dans le repère Rm est égale à la position estimée du centre géométrique de l'aimant permanent 100. Les orientations des axes $Z_{90}$ et $X_{90}$ sont égales aux orientations estimées des moments magnétiques, respectivement, des aimants 100 et 98.

De façon similaire, le calculateur 32 détermine la position et l'orientation du repère local $R_{110}$.

A l'issue de l'étape 178, chacune des équations supplémentaires identifiées exprime une égalité entre une première variable du modèle $M_5$ et un terme. La valeur de ce terme est exprimée à l'aide d'une ou plusieurs autres variables du modèle $M_5$ différentes de la première variable. Typiquement, ces autres variables du modèle $M_5$ sont celles qui codent la position et l'orientation des aimants permanents du même ustensile.

Ensuite, pour chaque équation supplémentaire, lors d'une étape 180, le calculateur 32 remplace, dans le système actuel d'équations du modèle $M_5$, la première variable par le terme auquel elle est égale. Ainsi, à l'issue de l'étape 180 on obtient un nouveau système d'équations et donc un nouveau modèle courant, noté $M_{5c}$, comportant moins de variables à estimer que le système actuel. Pour les étapes qui suivent le système d'équations du modèle $M_{5c}$ devient le système actuel d'équations.

Plus précisément le modèle $M_5$ initial est un modèle générique qui permet de localiser simultanément cinq aimants permanents sans tenir compte des relations mécaniques qui peuvent exister entre ces aimants permanents. Ce modèle $M_5$ est donc un système d'équations qui comporte trente variables à estimer. Après l'exécution de l'étape 180, le nouveau modèle $M_{5c}$ est un modèle spécifique qui dépend des ustensiles actuellement disposés sur la face 24. Ce modèle $M_{5c}$ prend notamment en compte les relations mécaniques qui limitent le nombre de degrés de liberté en déplacement des aimants permanents les uns par rapport aux autres. Il comporte donc moins de variables à estimer que le modèle $M_5$. Par exemple, ici, le modèle $M_{5c}$ comporte seulement 19 variables à estimer au lieu de trente. En effet, avant même d'avoir déterminé si les ustensiles 10, 90 et 110 sont immobiles où non dans le repère Rm et d'avoir remplacé leur moment magnétique par des constantes, il est possibles de simplifier le système actuel d'équations en utilisant les trois équations supplémentaires de l'ustensile 10 et les quatre équations supplémentaires de chacun des ustensiles 90 et 110.

Par la suite, les variables remplacées sont directement calculées à partir des équations supplémentaires identifiées et des valeurs estimées pour les variables du modèle $M_{5c}$.

Le procédé se poursuit par une étape 190 lors de laquelle les magnétomètres $M_{ij}$ mesurent le champ magnétique présent.

Lors d'une étape 192, le calculateur 32 acquiert ces mesures.

Lors d'une étape 194, le calculateur 32 estime la position et l'orientation de chaque aimant permanent en résolvant le système d'équations du modèle $M_{5c}$. Ce système d'équations est par exemple résolu comme décrit précédemment lors de l'opération 150.

Lors d'une étape 196, le calculateur 32 calcule également l'erreur d'estimation actuelle $E_{err}$ liée à l'utilisation du modèle $M_{5c}$. Cette erreur $E_{err}$ est calculée comme décrit lors de l'opération 150 sauf que c'est le modèle $M_{5c}$ qui est utilisé.

Ensuite, lors d'une étape 198, l'erreur $E_{err}$ est comparée à un seuil prédéterminé $S_{err}$. Si l'erreur $E_{err}$ est inférieure à ce seuil $S_{err}$, alors le calculateur 32 procède à une étape 200.

Lors de l'étape 200, les lois $L_i$ sélectionnées et les positions et orientations estimées lors de l'étape 194 sont utilisées pour générer une ou plusieurs commandes transmises à l'appareil 4. Ensuite, à l'issue de l'étape 200, le procédé retourne à l'étape 190.

Si l'erreur $E_{err}$ est supérieure au seuil $S_{err}$, alors on procède à une étape 202 de réintroduction d'une ou plusieurs variables dans le modèle courant $M_{5c}$ pour faire diminuer cette erreur $E_{err}$.

L'étape 202 peut être réalisée de nombreuses façons différentes. En effet, il existe de nombreuses méthodes pour réintroduire dans le modèle courant une ou plusieurs variables de manière à limiter l'erreur $E_{err}$. Par exemple, une première méthode consiste à retourner systématiquement à l'étape 146. Dans ce cas, l'ensemble des étapes à partir de l'étape 146 est réitéré à chaque fois que l'erreur $E_{err}$ dépasse le seuil $S_{err}$. Cette méthode présente l'avantage de permettre de réintroduire l'ensemble des variables des modèles $M_1$ à $M_5$. De plus, elle est simple à mettre en oeuvre.

Une deuxième méthode consiste à réintroduire les variables les unes après les autres dans l'ordre inverse où elles ont été éliminées du modèle courant. Ainsi, le calculateur 32 réintroduit dans le système actuel d'équations la dernière variable éliminée de manière à obtenir un nouveau système d'équations contenant une variable de plus. Ensuite, ce nouveau système d'équations est utilisé lors des mises en oeuvre suivantes des étapes 192 à 198. Cette deuxième méthode présente l'avantage qu'il n'est pas nécessaire de réitérer systématiquement l'étape 148 et la phase 166 d'adaptation automatique du modèle. Un autre avantage de cette méthode est que la dernière variable fixée est la plus susceptible d'être modifiée.

Une troisième méthode consiste à tester la réintroduction dans le modèle courant de chaque variable et de ne réintroduire que la variable ou les variables qui permettent de diminuer l'erreur $E_{err}$. Par exemple, pour cela, le calculateur 32 réintroduit d'abord une première variable dans le système actuel d'équations, puis vérifie si l'erreur $E_{err}$ calculée avec le nouveau système d'équations ainsi obtenu est inférieure à celle obtenue lors de la dernière itération de l'étape 196. Si l'erreur diminue, alors cette variable est sélectionnée. A l'inverse, si l'erreur n'est pas modifiée ou au contraire augmente, alors cette variable n'est pas sélectionnée. Le calculateur 32 teste ainsi chacune des variables du modèle courant $M_{5c}$ les unes après les autres. Ensuite, il réintroduit dans le modèle courant $M_{5c}$ toutes les variables sélectionnées.

Si la mise en oeuvre de la deuxième ou de la troisième méthode conduit à réintroduire dans le modèle courant toutes les variables et que malgré cela, l'erreur $E_{err}$ reste supérieure au seuil $S_{err}$, alors, le procédé retourne à l'étape 148. En effet, cela peut signifier que l'augmentation de l'erreur $E_{err}$ est alors peut-être causée par le retrait ou l'ajout d'un nouvel ustensile sur la face 24 qui modifie le nombre d'aimants permanents présents.

En parallèle des étapes 196 à 200, lors d'une étape 206, l'utilisateur manipule les ustensiles 10, 90 et 110 pour commander l'appareil 4.

Egalement en parallèle des étapes 196 à 200, le calculateur 32 exécute une seconde phase 210 d'adaptation automatique du modèle courant.

Cette phase 210 débute par une étape 211 d'identification d'une équation supplémentaire. Dans ce cas, lors de l'étape 211, l'équation supplémentaire est construite et non pas obtenue à partir d'informations préenregistrées sur les objets mobiles. Pour cela, lors d'une opération 212, le calculateur 32 calcule l'amplitude des variations de chaque variable du modèle $M_{5c}$ au cours des Q précédentes itérations des étapes 190 à 194. Typiquement Q est un nombre entier supérieur à dix et de préférence supérieur à cent ou mille. Par exemple, lors de l'opération 212, le calculateur 32 calcule la variance de chacune des variables du modèle $M_{5c}$.

Ensuite, lors d'une opération 214, le calculateur 32 compare chaque variance calculée à un seuil prédéterminé respectif $S_{var}$. Par exemple, le seuil $S_{var}$ est égal à une fraction de la variance maximale mesurée dans le passé pour cette variable. Par exemple, ce seuil $S_{var}$ est pris égal à 10 % ou 5 % ou 1 % de cette variance maximale mesurée. Le seuil $S_{var}$ peut aussi être une constante numérique prédéterminée.

Si la variance calculée lors de l'opération 212 est supérieure à ce seuil $S_{var}$, alors on considère que la valeur de cette variable varie et qu'aucune nouvelle équation supplémentaire n'est identifiée.

Dans le cas contraire, le calculateur 32 considère que cette variable ne varie plus, ce qui permet d'établir une nouvelle équation supplémentaire. Cette équation supplémentaire est une relation d'égalité entre cette variable et une constante numérique. La valeur de cette constante numérique est par exemple prise égale à la moyenne de plusieurs des précédentes valeurs estimées pour cette variable ou simplement prise égale à la dernière valeur estimée pour cette variable.

Ensuite, lors d'une étape 216, les variables qui sont considérées comme étant des constantes sont remplacées dans le modèle $M_{5c}$ par les valeurs de ces constantes. On obtient alors un nouveau système d'équations comportant encore moins de variables que le système actuel d'équations. Ce nouveau système d'équations est alors utilisé lors des exécutions suivantes des étapes 190 à 198. Il remplace donc le précédent système actuel d'équations.

Ainsi, la phase 210 permet d'adapter le modèle courant en exploitant le fait qu'en pratique, un degré de liberté d'un ustensile n'est pas nécessairement utilisé par l'utilisateur. Les équations supplémentaires ainsi construites sont ajoutées à dans la liste des ustensiles et des équations supplémentaires déjà identifiés. Ces variables éliminées lors de la phase 210 peuvent être réintroduite dans le système d'équations lors de l'étape 202.

Lorsque l'utilisateur souhaite reconfigurer l'interface 2. Il retourne à la phase 142. Lors de cette nouvelle exécution de la phase 142, il peut modifier la configuration de l'interface 2, par exemple :

- en enlevant ou en ajoutant un ustensile, et/ou
- en déplaçant un ustensile.

Ainsi, l'interface 2 est facilement configurable tout en restant simple à fabriquer.

De nombreux autres modes de réalisation sont possibles. Par exemple, la face avant 24 n'est pas nécessairement plane. Par exemple, en variante, il s'agit d'une forme en relief. Typiquement, cette forme en relief peut comporter des logements en creux destinés à recevoir et à immobiliser les ustensiles dans ces logements.

D'autres ustensiles que ceux précédemment décrits sont réalisables et utilisables dans l'interface 2. Par exemple, on pourra se référer à ce sujet à la demande de brevet FR1354160 déposé le 7 mai 2013 par le Commissariat à l'énergie atomique et aux énergies alternatives.

De nombreuses autres caractéristiques distinctives et conditions de sélection associées peuvent être conçues. Par exemple, lorsque l'ustensile comporte K aimants permanents, avec K strictement supérieur à un, la ou les caractéristiques distinctives de l'ustensile sont choisies dans le groupe composé de :

- la position relative des K aimants permanents les uns par rapport aux autres,
- l'orientation des moments magnétiques des K aimants permanents les uns par rapport aux autres,
- les amplitudes des moments magnétiques des K aimants permanents ou les amplitudes relatives des moments magnétiques des K aimants permanents les unes par rapport aux autres.

Lorsque la caractéristique distinctive est la position d'un aimant permanent d'un ustensile par rapport à la position d'un autre aimant permanent du même ustensile, il n'est pas nécessaire d'utiliser l'amplitude des moments magnétiques pour sélectionner l'ensemble $E_i$ à associer à cet ustensile.

Lorsque l'ustensile comporte seulement un aimant permanent, la caractéristique distinctive de l'ustensile est l'amplitude du moment magnétique de son aimant permanent.

La caractéristique distinctive peut aussi être la position d'un aimant permanent dans le repère Rm. Dans ce cas, la condition de sélection vérifie si cette aimant permanent est situé à l'intérieur d'une zone prédéfinie dans le repère Rm. Dans l'affirmative une loi de commande et un ensemble d'équations supplémentaires sont associés à cet ustensile. Il est également possible de définir des conditions vérifiant si la position d'un aimant est non pas située à l'intérieur d'un volume prédéfini mais dans une position particulière par rapport à un point fixe du repère Rm ou à un point dont la position est définie par un autre aimant permanent distinct de l'ustensile.

La caractéristique distinctive peut aussi être l'inclinaison du moment magnétique d'un aimant permanent par rapport à un axe de référence du repère Rm, par exemple la verticale. Dans ce cas, la condition de sélection teste si l'inclinaison estimée d'un moment magnétique d'un aimant permanent de l'ustensile est comprise dans une plage de valeurs prédéterminée. Dans l'affirmative, le calculateur identifie l'ensemble $E_i$ d'équations supplémentaires associé à cette condition de sélection comme permettant de réduire le nombre de variables du système actuel d'équations.

L'acquisition d'une caractéristique distinctive d'un objet peut être réalisée différemment de ce qui a été décrit. Par exemple, chaque objet est équipé d'une étiquette RFID, (Radio Frequency Identification). Dans ce cas, le dispositif 12 comporte en plus un lecteur d'étiquettes RFID. Ainsi, lorsqu'un ustensile est présenté devant le dispositif 12, celui-ci est identifié à partir de la lecture de l'identifiant de cet ustensile contenu dans son étiquette RFID. Ensuite, cet identifiant est utilisé pour sélectionner dans une base de données préenregistrée l'ensemble $E_i$ associé à cet ustensile. Ce même identifiant peut aussi être utilisé pour sélectionner la ou les lois de commande à utiliser avec cet ustensile. Ainsi, la caractéristique distinctive n'est pas nécessairement une caractéristique construite à partir des mesures des magnétomètres $M_{ij}$.

L'acquisition de la caractéristique distinctive n'est pas non plus nécessairement automatique. Par exemple, en variante, l'utilisateur indique, par l'intermédiaire d'une interface homme-machine l'identifiant du ou des objets ajoutés ou enlevés.

Dans un mode de réalisation où l'interface comporte uniquement un ou plusieurs exemplaires identiques du même ustensile, les conditions de sélection peuvent être omises. En effet, dans ce cas, l'ensemble $E_i$ d'équations supplémentaires associé à chaque ustensile est toujours le même. La base de données 38 peut alors contenir qu'un seul enregistrement. Il suffit simplement de dénombrer le nombre d'aimants permanents.

La base de données 38 ne contient pas nécessairement, en plus des ensembles $E_i$, les lois de commandes $L_i$. Par exemple, la base 38 contient uniquement les conditions Ci et les ensembles $E_i$ et une autre base de données contient des conditions $C'_i$ et les lois $L_i$. Dans ce cas les conditions Ci et $C'_i$ ne sont pas nécessairement les mêmes. Ainsi, un ensemble $E_i$ n'est pas nécessairement et systématiquement associé à la même loi de commande.

Si le nombre P d'aimants permanents simultanément présents devant la face 24 est connu à l'avance, le procédé de commande peut être simplifié en utilisant seulement le modèle $M_P$ correspondant pour déterminer la position, l'orientation et l'amplitude du moment magnétique de ces P aimants permanents. Par exemple, le nombre P d'aimants permanents est saisi par l'utilisateur lors de la phase de configuration. L'étape 148 peut donc être simplifiée.

Le changement de configuration de l'interface 2 n'est pas nécessairement réalisé directement à la main par un utilisateur. Dans une autre variante, l'interface comporte des actionneurs électriques permettant de modifier la configuration de l'interface. Par exemple, à cet effet, le déplacement des ustensiles ou le remplacement de ces ustensiles par d'autres ustensiles est motorisé, de sorte que l'utilisateur n'a pas lui-même à manipuler chacun de ces ustensiles.

Il est possible de limiter le nombre d'emplacements où un ustensile peut être disposé par rapport à la face avant 24. Pour cela, l'interface 2 comporte plusieurs emplacements, équipé chacun de détrompeur propre à empêcher la fixation à cet emplacement d'un certain nombre d'ustensiles et, au contraire, à autoriser la fixation à cet emplacement d'autres ustensiles différents.

L'approximation utilisée pour construire le modèle $M_P$ peut aussi être une approximation quaternaire ou supérieure, c'est-à-dire que les équations du magnétisme sont approximées à un ordre supérieur à celui correspondant à l'approximation dipolaire.

De nombreuses méthodes différentes sont utilisables pour déterminer la position et l'orientation de l'objet magnétique. Par exemple, la méthode décrite dans US6269324 est utilisable. Ces méthodes n'utilisent pas nécessairement un filtre de Kalman. Par exemple, les méthodes décrites dans US2002/171427A1 ou US6263230B1 sont possibles.

Les magnétomètres du réseau de magnétomètres ne sont pas nécessairement rangés en colonnes et en lignes. Ils peuvent être agencés aussi selon d'autres motifs. Par exemple, les magnétomètres sont disposés sur chaque sommet de chaque maille triangulaire ou hexagonale d'un maillage d'un plan.

La disposition des magnétomètres les uns par rapport aux autres peut aussi être aléatoire ou non régulière. Ainsi, la distance entre deux magnétomètres immédiatement consécutifs dans le réseau n'est pas nécessairement la même pour toutes les paires de deux magnétomètres immédiatement consécutifs. Par exemple, la densité de magnétomètres dans une zone donnée du réseau peut être plus importante qu'ailleurs. Augmenter la densité dans une zone donnée peut permettre d'augmenter la précision de la mesure dans cette zone.

Le réseau de magnétomètres peut aussi s'étendre dans trois directions non colinéaires de l'espace. Dans ces conditions, les magnétomètres sont répartis à l'intérieur d'un volume à trois dimensions.

Le nombre N de magnétomètres peut également être supérieur ou égal à soixante-quatre ou quatre-vingt dix.

Tous les magnétomètres du réseau de magnétomètres ne sont pas nécessairement identiques les uns aux autres. En variante, les magnétomètres n'ont pas tous la même sensibilité.

L'appareil 4 peut être remplacé par tout type d'appareil électrique qui doit être commandé en réponse à une action d'un être humain. Par exemple, l'appareil commandé peut être un robot, une machine-outil ou autre.

Dans tous les modes de réalisation décrits ici, l'aimant permanent peut être remplacé par un objet magnétique non alimenté en permanence et qui acquiert un moment magnétique en présent d'un champ magnétique continu extérieur, tel que le champ magnétique terrestre. Par exemple, l'aimant permanent est remplacé par une pièce en matériau magnétique doux. Un matériau magnétique est considéré comme doux si son champ magnétique coercitif est inférieur à 10 ou 1 A.m$^{-1}$. Une telle pièce présente un moment magnétique créé par l'interaction entre le champ magnétique terrestre et la pièce en matériau magnétique doux.

De nombreux autres modes de réalisation du procédé de la figure 6 sont possibles. Par exemple, l'une ou l'autre des phases 166 et 210 est omise.

Le nombre de mesures utilisées pour calculer la variance lors de l'opération 212 peut être fonction de la durée d'une fenêtre temporelle glissante. Typiquement, seules les mesures réalisées à l'intérieur de cette fenêtre temporelle glissante sont prises en compte pour calculer la variance.

**Revendications**

1. Procédé de localisation d'objets magnétiques mobiles présentés devant un réseau de magnétomètres comportant N magnétomètres tri-axes ($M_{ij}$) reliés mécaniquement les uns aux autres sans aucun degré de liberté pour conserver une distance connue entre chacun de ces magnétomètres, où N est un nombre entier supérieur ou égal à cinq, ce procédé comportant :

   a) la mesure (190) par chacun des magnétomètres de l'amplitude du champ magnétique le long de chacun de ses axes de mesure,
   b) l'estimation (194) à partir des mesures des magnétomètres, des valeurs de plusieurs variables en résolvant un système actuel d'équations reliant ces variables à chaque mesure d'un magnétomètre tri-axe du réseau, chaque variable correspondant à la position ou à l'orientation ou à l'amplitude d'un moment magnétique d'un objet magnétique,
   - l'itération des étapes a) et b) à des instants successifs dans le temps pour obtenir les valeurs estimées de chaque variable à ces différents instants successifs, **caractérisé en ce que** le procédé comporte :

   c) l'identification (168; 211), en fonction des objets mobiles présentés devant le réseau de magnétomètres, d'une équation supplémentaire reliant, par une relation d'égalité, une première variable du système actuel d'équations à un terme, ce terme étant une relation prédéfinie entre une ou plusieurs autres variables du système actuel d'équations ou une valeur numérique constante,
   d) le remplacement (180; 216), dans le système actuel d'équations, de cette première variable par le terme auquel elle est égale, identifié lors de l'étape c), pour obtenir un nouveau système d'équations dans lequel le nombre de variables dont la valeur doit être estimée est plus petit que dans le système actuel d'équations,

e) l'utilisation du nouveau système d'équations à la place du système actuel d'équations lors des itérations suivantes des étapes a) et b), le nouveau système d'équations devenant ainsi, pour les itérations suivantes des étapes a) et b), le système actuel d'équations.

**2.** Procédé selon la revendication 1, dans lequel l'identification (168 ; 211) de l'équation supplémentaire est réalisée en fonction des valeurs estimées, lors d'une précédente itération des étapes a) et b), des variables.

**3.** Procédé selon la revendication 2, dans lequel l'identification de l'équation supplémentaire comporte :

- le calcul (212) d'une grandeur représentative de l'amplitude des variations de la première variable au cours de précédentes itérations des étapes a) et b) à partir des valeurs de cette première variable estimée au cours de ces précédentes itérations des étapes a) et b),
- la comparaison (214) de cette grandeur calculée à un seuil prédéterminé pour établir si cette première variable a varié au cours de ces précédentes itérations des étapes a) et b), et
- si ce seuil prédéterminé est franchi, l'établissement (214) d'une nouvelle équation supplémentaire reliant, par une relation d'égalité, la valeur de cette première variable à une valeur constante, la valeur constante étant fonction d'au moins une valeur de cette première variable estimée lors de ces précédentes itérations des étapes a) et b) au cours desquelles il a été établi que sa valeur ne varie pas, puis l'utilisation de cette nouvelle équation supplémentaire lors de l'étape d), et
- si ce seuil prédéterminé n'est pas franchi, l'absence d'établissement de cette nouvelle équation supplémentaire.

**4.** Procédé selon l'une quelconque des revendications précédentes, dans lequel l'étape c) comporte :

- l'acquisition (170) d'une caractéristique distinctive de l'objet magnétique mobile actuellement présenté devant le réseau de magnétomètres, et
- la comparaison (172) de la caractéristique distinctive acquise à des conditions de sélection préenregistrées dans une base de données, cette base de données associant à chaque condition de sélection au moins une équation supplémentaire reliant, par une relation d'égalité, une variable du système actuel d'équations à un terme, ce terme étant une relation prédéfinie entre une ou plusieurs autres variables du système actuel d'équations ou une valeur numérique constante, et

- uniquement si la caractéristique distinctive acquise correspond à l'une des conditions de sélection préenregistrées, alors l'utilisation lors de l'étape d) de l'équation supplémentaire associée à cette condition de sélection.

**5.** Procédé selon la revendication 4, dans lequel l'acquisition d'une caractéristique distinctive comporte l'obtention (170) de cette caractéristique distinctive à partir des valeurs des variables estimées à l'aide du système actuel d'équations.

**6.** Procédé selon l'une quelconque des revendications précédentes, dans lequel le procédé comporte :

- le calcul (198) d'une erreur d'estimation avec le système actuel d'équations, l'erreur d'estimation étant représentative de l'écart entre :

    • des valeurs estimées des mesures des magnétomètres lorsque la position, l'orientation et l'amplitude du moment magnétique de chaque objet magnétique sont égales à celles estimées en utilisant le système actuel d'équations lors d'une itération des étapes a) et b), et
    • les mesures des magnétomètres relevées à l'étape a) lors de la même itération des étapes a) et b), et

- si l'erreur d'estimation calculée franchit un seuil prédéterminé :

    • la sélection (202) d'au moins une des équations supplémentaires précédemment utilisées lors de l'étape d) pour obtenir le système actuel d'équations,
    • le remplacement (202), dans le système actuel d'équations, du terme de l'équation supplémentaire sélectionnée, par la variable que ce terme a remplacé pour obtenir un nouveau système d'équations dans lequel le nombre de variables dont la valeur doit être estimée est plus grand que dans le système actuel d'équations et l'utilisation du nouveau système d'équations à la place du système actuel d'équations lors des itérations suivantes des étapes a) et b), et

- si l'erreur calculée ne franchit pas ce seuil prédéterminé, le maintien de l'utilisation du système actuel d'équations lors des itérations suivantes des étapes a) et b).

7. Procédé selon la revendication 6, dans lequel la sélection d'au moins une équation supplémentaire comporte :

- la sélection d'au moins deux équations supplémentaires précédemment utilisées lors de l'étape d) pour obtenir le système actuel d'équations,
- pour chacune des équations supplémentaires sélectionnées, le remplacement, dans le système actuel d'équations, du terme de l'équation supplémentaire sélectionnée, par la variable que ce terme a remplacée pour obtenir des troisième est quatrième systèmes d'équations différents, chacun de ces quatrième et troisième systèmes d'équations comportant un nombre de variables dont la valeur doit être estimée plus grand que dans le système actuel d'équations,
- le calcul de l'erreur d'estimation avec ces troisième et quatrième systèmes d'équations, et
- la sélection de l'équation supplémentaire, parmi celles initialement sélectionnées, qui minimise l'erreur d'estimation calculée.

8. Support (34) d'enregistrement d'informations, **caractérisé en ce qu'**il comporte des instructions pour l'exécution d'un procédé conforme à l'une quelconque des revendications précédentes, lorsque ces instructions sont exécutées par un calculateur électronique.

9. Dispositif de localisation d'objets magnétiques mobiles, ce dispositif comportant :

- un réseau de magnétomètres comportant N magnétomètres tri-axes ($M_{ij}$) reliés mécaniquement les uns aux autres sans aucun degré de liberté pour conserver une distance connue entre chacun de ces magnétomètres, où N est un nombre entier supérieur ou égal à cinq,
- une unité (30) de traitement configurée

a) à acquérir les mesures de chacun des magnétomètres du réseau de magnétomètres,
b) à estimer, à partir des mesures des magnétomètres, des valeurs de plusieurs variables en résolvant un système actuel d'équations reliant ces variables à chaque mesure d'un magnétomètre tri-axe du réseau, chaque variable correspondant à la position ou à l'orientation ou à l'amplitude d'un moment magnétique d'un objet magnétique,

- à réitérer les étapes a) et b) à des instants successifs dans le temps pour obtenir les valeurs estimées de chaque variable à ces différentes instants successifs, **caractérisé en ce que** l'unité (30) de traitement est également configurée :

c) à identifier, en fonction des objets mobiles présentés devant le réseau de magnétomètres, une équation supplémentaire reliant, par une relation d'égalité, une première variable du système actuel d'équations à un terme, ce terme étant une relation prédéfinie entre une ou plusieurs autres variables du système actuel d'équations ou une valeur numérique constante,
d) à remplacer, dans le système actuel d'équations, cette première variable par le terme auquel elle est égale, identifié lors de l'étape c), pour obtenir un nouveau système d'équations dans lequel le nombre de variables dont la valeur doit être estimée est plus petit que dans le système actuel d'équations,
e) à utiliser le nouveau système d'équations à la place du système actuel d'équations lors des itérations suivantes des étapes a) et b), le nouveau système d'équations devenant ainsi, pour les itérations suivantes des étapes a) et b), le système actuel d'équations.

**Patentansprüche**

1. Verfahren zur Lokalisierung beweglicher magnetischer Gegenstände, die vor einem Magnetometernetz präsentiert werden, das N dreiachsige Magnetometer ($M_{ij}$) aufweist, die mechanisch ohne jeden Freiheitsgrad miteinander verbunden sind, um einen bekannten Abstand zwischen jedem dieser Magnetometer beizubehalten, wobei N eine ganze Zahl größer als oder gleich fünf ist, wobei dieses Verfahren aufweist:

a) die Messung (190), durch jedes der Magnetometer, der Amplitude des Magnetfelds entlang jeder seiner Messachsen,
b) die Schätzung (194), ausgehend von den Messungen der Magnetometer, der Werte mehrerer Variablen durch Lösen eines aktuellen Gleichungssystems, das diese Variablen mit jeder Messung eines dreiachsigen Magnetometers des Netzes verbindet, wobei jede Variable der Stellung oder der Ausrichtung oder der Amplitude eines magnetischen Moments eines magnetischen Gegenstands entspricht,

- die Iteration der Schritte a) und b) zu zeitlich aufeinanderfolgenden Zeitpunkten, um die geschätzten Werte jeder Variablen zu diesen aufeinanderfolgenden verschiedenen Zeitpunkten zu erhalten,

**dadurch gekennzeichnet, dass** das Verfahren aufweist:

c) die Identifizierung (168; 211), abhängig von den vor dem Magnetometernetz präsentierten beweglichen Gegenständen, einer zusätzlichen Gleichung, die durch eine Gleichheitsbeziehung eine erste Variable des aktuellen Gleichungssystems mit einem Term verbindet, wobei dieser Term eine vordefinierte Beziehung zwischen einer oder mehreren anderen Variablen des aktuellen Gleichungssystems oder einem konstanten numerischen Wert ist,

d) den Ersatz (180; 216), im aktuellen Gleichungssystem, dieser ersten Variablen durch den Term, dem sie gleich ist, identifiziert im Schritt c), um ein neues Gleichungssystem zu erhalten, in dem die Anzahl von Variablen, deren Wert geschätzt werden soll, kleiner ist als im aktuellen Gleichungssystem,

e) die Verwendung des neuen Gleichungssystems anstelle des aktuellen Gleichungssystems bei den folgenden Iterationen der Schritte a) und b), wobei das neue Gleichungssystem so für die folgenden Iterationen der Schritte a) und b) das aktuelle Gleichungssystem wird.

2. Verfahren nach Anspruch 1, wobei die Identifizierung (168; 211) der zusätzlichen Gleichung abhängig von den in einer vorhergehenden Iteration der Schritte a) und b) geschätzten Werten der Variablen durchgeführt wird.

3. Verfahren nach Anspruch 2, wobei die Identifizierung der zusätzlichen Gleichung aufweist:

- die Berechnung (212) einer Größe, die für die Amplitude der Variationen der ersten Variablen während vorhergehender Iterationen der Schritte a) und b) ausgehend von den Werten dieser ersten Variablen repräsentativ ist, die während dieser vorhergehenden Iterationen der Schritte a) und b) geschätzt wurde,
- den Vergleich (214) dieser berechneten Größe mit einer vorbestimmten Schwelle, um festzustellen, ob diese erste Variable sich während dieser vorhergehenden Iterationen der Schritte a) und b) geändert hat, und
- wenn diese vorbestimmte Schwelle überschritten wird, die Erstellung (214) einer neuen zusätzlichen Gleichung, die durch eine Gleichheitsbeziehung den Wert dieser ersten Variablen mit einem konstanten Wert verbindet, wobei der konstante Wert von mindestens einem Wert dieser ersten Variablen abhängt, die bei diesen vorhergehenden Iterationen der Schritte a) und b) geschätzt wurde, während denen festgestellt wurde, dass ihr Wert sich nicht ändert, dann die Verwendung dieser neuen zusätzlichen Gleichung im Schritt d), und
- wenn diese vorbestimmte Schwelle nicht überschritten wird, die Abwesenheit der Erstellung dieser neuen zusätzlichen Gleichung.

4. Verfahren nach einem der vorhergehenden Ansprüche, wobei der Schritt c) aufweist:

- die Erfassung (170) eines unterscheidenden Merkmals des aktuell vor dem Magnetometernetz präsentierten beweglichen magnetischen Gegenstands, und
- den Vergleich (172) des erfassten unterscheidenden Merkmals mit vorab in einer Datenbank gespeicherten Auswahlbedingungen, wobei diese Datenbank jeder Auswahlbedingung mindestens eine zusätzliche Gleichung zuordnet, die durch eine Gleichheitsbeziehung eine Variable des aktuellen Gleichungssystems mit einem Term verbindet, wobei dieser Term eine vordefinierte Beziehung zwischen einer oder mehreren anderen Variablen des aktuellen Gleichungssystems oder einem konstanten numerischen Wert ist, und
- nur wenn das erfasste unterscheidende Merkmal einer der vorab gespeicherten Auswahlbedingungen entspricht, dann die Verwendung im Schritt d) der dieser Auswahlbedingung zugeordneten zusätzlichen Gleichung.

5. Verfahren nach Anspruch 4, wobei die Erfassung eines unterscheidenden Merkmals den Erhalt (170) dieses unterscheidenden Merkmals ausgehend von den Werten der mit Hilfe des aktuellen Gleichungssystems geschätzten Variablen aufweist.

6. Verfahren nach einem der vorhergehenden Ansprüche, wobei das Verfahren aufweist:

- die Berechnung (198) eines Schätzfehlers mit dem aktuellen Gleichungssystem, wobei der Schätzfehler repräsentativ ist für die Abweichung zwischen:

• geschätzten Werten der Messungen der Magnetometer, wenn die Stellung, die Ausrichtung und die Amplitude des magnetischen Moments jedes magnetischen Gegenstands gleich denen sind, die unter Verwendung des aktuellen Gleichungssystems bei einer Iteration der Schritte a) und b) geschätzt werden, und

• den im Schritt a) erfassten Messwerten der Magnetometer bei der gleichen Iteration der Schritte a) und b), und

- wenn der berechnete Schätzfehler eine vorbestimmte Schwelle überschreitet:

• die Auswahl (202) mindestens einer der zusätzlichen Gleichungen, die vorher im Schritt d) verwendet wurden, um das aktuelle Gleichungssystem zu erhalten, • den Ersatz (202), im aktuellen Gleichungssystem, des Terms der ausgewählten zusätzlichen Gleichung durch die Variable, die dieser Term ersetzt hat, um ein neues Gleichungssystem zu erhalten, wobei die Anzahl von Variablen, deren Wert geschätzt werden soll, größer ist als im aktuellen Gleichungssystem, und die Verwendung des neuen Gleichungssystems anstelle des aktuellen Gleichungssystems bei den folgenden Iterationen der Schritte a) und b), und

- wenn der berechnete Fehler diese vorbestimmte Schwelle nicht überschreitet, die Beibehaltung der Verwendung des aktuellen Gleichungssystems bei den folgenden Iterationen der Schritte a) und b).

**7.** Verfahren nach Anspruch 6, wobei die Auswahl mindestens einer zusätzlichen Gleichung aufweist:

- die Auswahl von mindestens zwei zusätzlichen Gleichungen, die vorher im Schritt d) verwendet wurden, um das aktuelle Gleichungssystem zu erhalten, - für jede der ausgewählten zusätzlichen Gleichungen den Ersatz, im aktuellen Gleichungssystem, des Terms der ausgewählten zusätzlichen Gleichung durch die Variable, die dieser Term ersetzt hat, um dritte und vierte unterschiedliche Gleichungssysteme zu erhalten, wobei jedes dieser vierten und dritten Gleichungssysteme eine Anzahl von Variablen aufweist, deren Wert geschätzt werden soll, die größer ist als im aktuellen Gleichungssystem, - die Berechnung des Schätzfehlers mit diesen dritten und vierten Gleichungssystemen, und - die Auswahl der zusätzlichen Gleichung unter den ursprünglich ausgewählten, die den berechneten Schätzfehler minimiert.

**8.** Datenaufzeichnungsträger (34), **dadurch gekennzeichnet, dass** er Anweisungen zur Ausführung eines Verfahrens nach einem der vorhergehenden Ansprüche aufweist, wenn diese Anweisungen von einem elektronischen Rechner ausgeführt werden.

**9.** Vorrichtung zur Lokalisierung von beweglichen magnetischen Gegenständen, wobei diese Vorrichtung aufweist:

- ein Magnetometernetz, das N dreiachsige Magnetometer ($M_{ij}$) aufweist, die mechanisch ohne jeden Freiheitsgrad miteinander verbunden sind, um einen bekannten Abstand zwischen jedem dieser Magnetometer beizubehalten, wobei N eine ganze Zahl größer als oder gleich fünf ist, - eine Verarbeitungseinheit (30), die konfiguriert ist:

a) die Messungen jedes der Magnetometer des Magnetometernetzes zu erfassen, b) ausgehend von den Messungen der Magnetometer Werte mehrerer Variablen zu schätzen, indem ein aktuelles Gleichungssystem gelöst wird, das diese Variablen mit jeder Messung eines dreiachsigen Magnetometers des Netzes verbindet, wobei jede Variable der Stellung oder der Ausrichtung oder der Amplitude eines magnetischen Moments eines magnetischen Gegenstands entspricht,

- die Schritte a) und b) zu zeitlich aufeinanderfolgenden Zeitpunkten zu wiederholen, um die geschätzten Werte jeder Variablen zu diesen aufeinanderfolgenden verschiedenen Zeitpunkten zu erhalten,

**dadurch gekennzeichnet, dass** die Verarbeitungseinheit (30) ebenfalls konfiguriert ist:

c) abhängig von den vor dem Magnetometernetz präsentierten beweglichen Gegenständen eine zusätzliche Gleichung zu identifizieren, die durch eine Gleichheitsbeziehung eine erste Variable des aktuellen Gleichungssystems mit einem Term verbindet, wobei dieser Term eine vordefinierte Beziehung zwischen einer oder mehreren anderen Variablen des aktuelles Gleichungssystems oder einem konstanten numerischen Wert ist, d) im aktuellen Gleichungssystem diese erste Variable durch den Term zu ersetzen, dem sie gleich ist, identifiziert im Schritt c), um ein neues Gleichungssystem zu erhalten, wobei die Anzahl von Variablen, deren Wert geschätzt werden soll, kleiner ist als im aktuellen Gleichungssystem, e) das neue Gleichungssystem anstelle des aktuellen Gleichungssystems bei den folgenden Iterationen der Schritte a) und b) zu verwenden, wobei das neue Gleichungssystem so für die folgenden Iterationen der Schritte a) und b) das aktuelle Gleichungssystem wird.

## Claims

1. Method for locating mobile magnetic objects presented before a network of magnetometers having N triaxial magnetometers ($M_{ij}$) that are mechanically connected to one another without any degree of freedom in order to preserve a known distance between each of said magnetometers, where N is an integer greater than or equal to five, said method involving:

a) the measurement (190), by each of the magnetometers, of the amplitude of the magnetic field along each of the measurement axes thereof,

b) the estimation (194), on the basis of the measurements from the magnetometers, of the values of a plurality of variables by resolving a current system of equations connecting said variables to each measurement from a triaxial magnetometer of the network, each variable corresponding to the position or to the orientation or to the amplitude of a magnetic moment of a magnetic object,

- the iteration of steps a) and b) at successive instants in time in order to obtain the estimated values of each variable at said various successive instants,

**characterized in that** the method involves:

c) the identification (168; 211), on the basis of the mobile objects presented before the network of magnetometers, of a supplementary equation connecting, by means of a relationship of equality, a first variable from the current system of equations to a term, said term being a predefined relationship between one or more other variables from the current system of equations or a constant numerical value,

d) the replacement (180; 216), in the current system of equations, of said first variable with the term to which it is equal, identified in step c), in order to obtain a new system of equations in which the number of variables for which the value needs to be estimated is smaller than in the current system of equations,

e) the use of the new system of equations instead of the current system of equations for the subsequent iterations of steps a) and b), the new system of equations thus becoming, for the subsequent iterations of steps a) and b), the current system of equations.

2. Method according to Claim 1, in which the identification (168; 211) of the supplementary equation is performed as a function of the estimated values, from a previous iteration of steps a) and b), of the variables.

3. Method according to Claim 2, in which the identification of the supplementary equation involves:

- the calculation (212) of a magnitude that is representative of the amplitude of the variations in the first variable in the course of previous iterations of steps a) and b) on the basis of the values of said first variable, which is estimated in the course of said previous iterations of steps a) and b),
- the comparison (214) of said calculated magnitude with a predetermined threshold in order to establish whether said first variable has varied in the course of said previous iterations of steps a) and b), and
- if said predetermined threshold is crossed, the establishment (214) of a new supplementary equation connecting, by means of a relationship of equality, the value of said first variable to a constant value, the constant value being a function of at least one value of said first variable that is estimated at the time of said previous iterations of steps a) and b), in the course of which it has been established that the value thereof does not vary, and the use of said new supplementary equation in step d), and
- if said predetermined threshold is not crossed, the absence of establishment of said new supplementary equation.

4. Method according to any one of the preceding claims, in which step c) involves:

- the acquisition (170) of a distinctive feature of the mobile magnetic object currently presented before the network of magnetometers, and
- the comparison (172) of the acquired distinctive feature with selection conditions prerecorded in a database, said database associating with each selection condition at least one supplementary equation connecting, by means of a relationship of equality, a variable from the current system of equations to a term, said term being a predefined relationship between one or more other variables from the current system of equations or a constant numerical value, and
- only if the acquired distinctive feature corresponds to one of the prerecorded selection conditions, the use in step d) of the supplementary equation associated with said selection condition.

5. Method according to Claim 4, in which the acquisition of a distinctive feature involves the obtainment (170) of said distinctive feature on the basis of the values of the variables estimated using the current system of equations.

6. Method according to any one of the preceding claims, in which the method involves:

   - the calculation (198) of an estimation error with the current system of equations, the estimation error being representative of the difference between:

      • estimated values of the measurements from the magnetometers when the position, the orientation and the amplitude of the magnetic moment of each magnetic object are equal to those estimated using the current system of equations at the time of an iteration of steps a) and b), and
      • the measurements from the magnetometers that are taken in step a) at the time of the same iteration of steps a) and b), and

   - if the calculated estimation error crosses a predetermined threshold:

      • the selection (202) of at least one of the supplementary equations previously used in step d) in order to obtain the current system of equations,
      • the replacement (202), in the current system of equations, of the term from the selected supplementary equation with the variable that said term has replaced in order to obtain a new system of equations in which the number of variables for which the value needs to be estimated is larger than in the current system of equations and the use of the new system of equations instead of the current system of equations for the subsequent iterations of steps a) and b), and

   - if the calculated error does not cross said predetermined threshold, maintenance of the use of the current system of equations for the subsequent iterations of steps a) and b).

7. Method according to Claim 6, in which the selection of at least one supplementary equation involves:

   - the selection of at least two supplementary equations previously used in step d) in order to obtain the current system of equations,
   - for each of the selected supplementary equations, the replacement, in the current system of equations, of the term from the selected supplementary equation with the variable that said term has replaced in order to obtain third and fourth different systems of equations, each of said fourth and third systems of equations having a number of variables for which the value needs to be estimated larger than in the current system of equations,
   - the calculation of the estimation error with said third and fourth systems of equations, and
   - the selection of the supplementary equation, among those initially selected, that minimises the calculated estimation error.

8. Information recording medium (34), **characterized in that** it has instructions for the execution of a method according to any one of the preceding claims when said instructions are executed by an electronic computer.

9. Device for locating mobile magnetic objects, said device having:

   - a network of magnetometers having N triaxial magnetometers ($M_{ij}$) mechanically connected to one another without any degree of freedom in order to preserve a known distance between each of said magnetometers, where N is an integer greater than or equal to five,
   - a processing unit (30) configured:

      a) for acquiring the measurements from each of the magnetometers of the network of magnetometers,
      b) for estimating, on the basis of the measurements from the magnetometers, values of a plurality of variables by resolving a current system of equations connecting said variables to each measurement from a triaxial magnetometer of the network, each variable corresponding to the position or to the orientation or to the amplitude of a magnetic moment of a magnetic object,

         - for reiterating steps a) and b) at successive instants in time in order to obtain the estimated values of each variable at said various successive instants,

   **characterized in that** the processing unit (30) is likewise configured:

      c) for identifying, on the basis of the mobile objects presented before the network of magnetometers, a supplementary equation connecting, by means of a relationship of equality, a first variable from the current system of equations to a term, said term being a predefined relationship between one or more other variables from the current system of equations or a constant numerical value,

d) for replacing, in the current system of equations, said first variable with the term to which it is equal, identified in step c), in order to obtain a new system of equations in which the number of variables for which the value needs to be estimated is smaller than in the current system of equations,

e) for using the new system of equations instead of the current system of equations for the subsequent iterations of steps a) and b), the new system of equations thus becoming, for the subsequent iterations of steps a) and b), the current system of equations.

## Fig. 1

## Fig. 2

$R_{90}$  $z_{90}$  $x_{90}$  $y_{90}$

Fig. 3

$R_{110}$  $z_{110}$  $x_{110}$  $y_{110}$

Fig. 4

$C_1$
$C_2$
$C_3$

$L_1$
$L_2$
$L_3$

$E_1$
$E_2$
$E_3$

Fig. 5

EP 2 884 372 B1

Fig. 6

22

**EP 2 884 372 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2988862
- FR 2988874
- US 7932718 B1
- US 2003095115 A1
- FR 2952450 A1
- US 2002171427 A1
- FR 2988862 A1
- GB 2310930 A
- FR 1354160
- US 6269324 B
- US 6263230 B1